# NEUE EUROPÄISCHE PATENTSCHRIFT

(11) **EP 1 030 349 B2**
(45) Veröffentlichungstag und Bekanntmachung des Hinweises auf die Entscheidung über den Einspruch: **11.12.2013**
(45) Hinweis auf die Patenterteilung: 07.07.2004
(21) Anmeldenummer: 99112660.8
(22) Anmeldetag: 02.07.1999
(51) Int. Cl.: H01L 21/00

(54) **Verfahren und Vorrichtung zum Behandeln von auf einem Substrat angeordneten elektronischen Bauteilen, insbesondere von Halbleiterchips**
Method and apparatus for treating electronic components mounted on a substrate, in particular semiconductor chips
Méthode et dispositif pour le traitement de composants électroniques montés sur substrat, en particulier de puces semi-conductrices

(30) Priorität: 07.01.1999 EP 99810009
(43) Veröffentlichungstag der Anmeldung: 23.08.2000
(73) Patentinhaber: Kulicke & Soffa Die Bonding GmbH, 8572 Berg TG (CH)
(72) Erfinder: Wirz, Gustav, 8572 Berg (CH)
(74) Vertreter: Körner, Thomas Ottmar

(56) Entgegenhaltungen:
- WO-A-97/32460
- WO-A1-95/31004
- JP-A- H1 050 930
- US-A- 5 144 747
- US-A- 5 658 831
- US-B1- 6 200 504
- PATENT ABSTRACTS OF JAPAN vol. 1999, no. 03, 31. März 1999 (1999-03-31) -& JP 10 321679 A (SEIKO EPSON CORP), 4. Dezember 1998 (1998-12-04)
- PATENT ABSTRACTS OF JAPAN vol. 1999, no. 09, 30. Juli 1999 (1999-07-30) & JP 11 121532 A (MATSUSHITA ELECTRIC IND CO LTD), 30. April 1999 (1999-04-30)

## Beschreibung

Die Erfindung betrifft ein Verfahren und eine Vorrichtung zum Behandeln von auf einem Substrat angeordneten Bauteilen, insbesondere von Halbleiterchips. Derartige Verfahren werden beispielsweise bei der Herstellung bestimmter Halbleiterelemente eingesetzt, bei denen der fertige mit Anschlussteilen versehene Chip nur unwesentlich grösser ist als der rohe Siliziumchip (Chip Scale Package oder kurz CSP).

Dabei wird zwischen dem Substrat und dem Bauteil eine Puffermasse, beispielsweise aus einem Elastomer oder einer Folie angeordnet, welche die unterschiedlichen, thermischen Längenausdehnungskoeffizienten der Werkstoffe kompensiert. Um eine ausreichende Haftung zu gewährleisten und um die Elastomermasse auszuhärten, müssen die Bauteile bei gleichzeitiger Erwärmung gegen das Substrat gepresst werden. Dies geschieht mittels einer Presse zwischen parallelen Platten,welche geheizt werden können.

Ein Nachteil der bekannten Verfahren besteht jedoch darin, dass die exakte Platzierung der Bauteile auf dem Substrat und die endgültige Verbindung unter hohem Druck und bei hoher Temperatur in einem Schritt erfolgt. Der Pressvorgang dauert dabei wesentlich länger als der Platziervorgang, was zu starken Kapazitatseinschränkungen in der Produktionslinie führt. Andererseits ist aber auch der Einsatz hoher Temperaturen im Bereich der Platzierung der Bauteile storend An der Platzierstation wird nämlich mit hochpräzisen Manipulatoren und Messgeräten gearbeitet, welche empfindlich auf Temperatureinwirkungen reagieren. Es ist daher eine Aufgabe der Erfindung, ein Verfahren der Eingangs genannten Art zu schaffen, bei dem mit einfachen Mitteln die Produktionskapazität innerhalb der gleichen Linie erhöht werden kann. Ausserdem soll das Verfahren eine Trennung des Aufsetzvorgangs vom eigentlichen Behandlungsvorgang fur die definitive Verbindung erlauben.

Diese Aufgabe wird erfindungsgemäss mit einem Verfahren gelöst, das die Merkmale im Anspruch 1 aufweist. Das gruppenweise Anpressen und/oder Erwärmen der Bauteile erfolgt dabei zeitlich getrennt vom Aufsetzvorgang, sodass je nach Werkzeuggrösse eine relativ grosse Zahl von Bauteilen gleichzeitig behandelt werden können.

Besonders vorteilhaft erfolgt dabei das Auflegen der Bauteile auf das Substrat und das Beaufschlagen mit dem Werkzeug an im Abstand voneinander angeordneten Arbeitsstationen. Es hat sich nämlich gezeigt, dass die exakte Platzierung und die Behandlung nicht zwingend an der gleichen Arbeitsstation erfolgen muss. Beim Einsatz geeigneter Substrate bzw. Klebstoffe verfügen diese auch bei Raumtemperatur über ausreichende Klebkraft für den Weitertransport nach der Platzierung Damit können die Substrate vom sensiblen Platzierungsbereich wegtransportiert werden zu einer Behandlungsstation, an der ohne negative Beeinflussung des Platzierungsvorgangs Druck und/oder Wärme appliziert werden kann.

Mehrere nacheinander folgende Gruppen von Bauteilen können dabei taktweise beaufschlagt werden, wobei die Beaufschlagung einer Gruppe im Idealfall maximal solange dauert, wie das Auflegen einer vorausgehenden Gruppe. Beim Aufsetzvorgang können dabei in rascher Folge die Bauteile zu einer Gruppe angeordnet werden, wobei auf der Behandlungsstation während der ganzen Zeitspanne vom Platzieren des ersten Bauteils bis zum Platzieren des letzten Bauteils gepresst wird. Erhebliche Vorteile bei der Behandlung der Bauteile können ferner erreicht werden, wenn jedes Bauteil der Gruppe mit einem separaten Stossel beaufschlagt wird und wenn bei der Beaufschlagung zur Erzielung einer gleichförmigen Auflagekraft auf allen Bauteilen jeder Stossel der individuellen Höhe des Bauteils angepasst wird. Mit dieser Massnahme ist gewahrleistet, dass auch bei den unvermeidbaren Höhentoleranzen der Bauteile eine gleichformige Behandlung der ganzen Gruppe mit Druck und Temperatur erfolgt. Ein Bauteil mit einer maximal gerade noch zulässigen Höhe wird somit der gleichen Presskraft und der gleichen Temperatur unterworfen wie ein Bauteil mit einer zulässigen Mindesthöhe.

Für die Wärmebehandlung werden vor und/oder während der Beaufschlagung der Bauteile die Stössel und/oder eine als Widerlager dienende Substratauflage beheizt. Es wäre aber auch denkbar, den gesamten Pressvorgang in einem geschlossenen Ofen auszuführen oder die Erwärmung auf andere Weise zu bewirken, z B. durch einen Konvektionsofen oder durch Mikrowellen. Das Substrat wird ausserdem während der Beaufschlagung der Bauteile vorteilhaft mittels Unterdruck auf der Substratauflage gehalten. Da es sich beim Substrat in der Regel um ein filmartiges oder gelartiges Material handelt, wird damit auch ein flächiges Aufliegen auf der Substratauflage ohne Lufteinschlüsse gewährleistet.

Durch die JP 11-121532 ist eine gattungsmässig vergleichbare Vorrichtung bekannt geworden, bei der mit einem einzigen Werkzeug gleichzeitig mehrere auf einem Substrat angeordnete elektronische Bauteile unterschiedlicher Bauart behandelt werden können. Das Werkzeug verfügt zu diesem Zweck über mehrere einzelne Anpresswerkzeuge, welche in Anpressrichtung verschiebbar in einer Führung gelagert sind und von denen jedes individuell mit einem separat ansteuerbaren Pneumatikzylinder beaufschlagbar ist. Zur Anpassung der Ausgangslage jedes Anpresswerkzeugs an die Bauhöhe der elektronischen Bauteile kann die maximal mögliche Endlage jedes Werkzeugs an der Führung mit einem Anschlag begrenzt werden. So ist gewährleistet, dass alle Bauteile gleichzeitig mit den Werkzeugen in Berührung kommen.

Die JP 10050930 A beschreibt ein Verfahren zur Befestigung mehrerer Chips auf einem Substrat unter hydrostatischem Druck in einem verschlossenen Container.

Ferner beschreibt JP 10-321679 eine Vorrichtung und ein Verfahren zum Befestigen von Treiberchips für eine Flüssigkristallanzeige auf deren Glassubstrat.

Die Erfindung betrifft auch eine Vorrichtung zum Behandeln von auf einem Substrat angeordneten elektronischen Bauteilen gemäss dem Oberbegriff von Anspruch 4. Diese Vorrichtung eignet sich besonders vorteilhaft zur Durchführung des erfindungsgemässen Verfahrens, könnte aber auch anderweitig eingesetzt werden. Die Vorrichtung soll insbesondere gewährleisten, dass trotz der gruppenweisen Behandlung der Bauteile deren individuelle Beschaffenheit wie bei einer Einzelbehandlung berücksichtigt werden kann. Dies wird erfindungsgemäß durch die Vorrichtung gemäß Anspruch 4 gelöst, sowie die Verwendung der Vorrichtung gemäß Anspruch 15.

Die einzeln und verschiebbar gelagerten Stössel im Werkzeug ermöglichen es, jedes einzelne Bauteil einer Gruppe individuell zu behandeln. Denkbar wäre somit auch die Ausübung einer individuellen Temperatur. Die einzelnen Stössel könnten auch unterschiedlich geformt sein, sodass innerhalb einer Gruppe unterschiedliche Grössen und/oder Formen von Bauteilen beaufschlagt werden können.

Bei der eingangs beschriebenen Fertigung von Halbleiterelementen müssen jedoch in der Regel nur die unterschiedlichen Höhen der rohen Siliziumchips berücksichtigt werden. Dies erfolgt dadurch, dass die Stössel mit einem Kompensationsmittel in Wirkverbindung stehen. Dieses Kompensationsmittel kann nach unterschiedlichen technischen Prinzipien arbeiten. So wäre beispielsweise eine rein mechanische Lösung denkbar, bei der in einer neutralen Ausgangsstellung des Werkzeugs die verschiebbaren Stössel lose auf die Bauteile aufgelegt werden. Über eine Zentralverriegelung werden sodann alle Stössel in ihrem Schiebelager arretiert, wonach über das Werkzeug die Presskraft über die individuell justierten Stössel ausgeübt wird.

Auf besonders einfache Weise wird das Kompensationsmittel wird durch eine Flüssigkeitskammer für die hydrostatische Verteilung der Beaufschlagungskraft auf die einzelnen Stössel gebildet. Diese Flüssigkeitskammer arbeitet nach dem bekannten Prinzip, wonach sich in einer praktisch nicht komprimierbaren ruhenden Flüssigkeit die Druckkräfte richtungsunabhängig ausbreiten. Die Stössel könnten somit jeder mit einer gleichen Beaufschlagungsfläche in die Flüssigkeitskammer eintauchen, deren Wände im übrigen starr sind.

Eine technisch wesentlich einfachere Lösung besteht jedoch darin, dass die Flussigkeitskammer auf den von der Substratauflage abgewandten Rückseiten der Stössel angeordnet ist und dass sie eine flexible Membrane aufweist, wobei die Rückseiten der Stössel an der Membrane anliegen. Das Volumen in der Kammer bleibt stets gleich gross, unabhängig davon, wie die Stössel positioniert sind. Die Elastizität der Membrane erlaubt dabei innerhalb eines bestimmten Toleranzbereiches eine Verschiebung der Stössel. Der Druck in der Flüssigkeit und damit der Druck auf die einzelnen Stössel bleibt dabei jedoch stets gleich.

Zur Überwachung und Steuerung oder gegebenenfalls auch zur Protokollierung der auf die Stössel wirkenden Presskraft kann die Flüssigkeitskammer mit einem Drucksensor in Wirkverbindung stehen. Es ist auch bei Werkzeugen ohne Flüssigkeitskammer generell vorteilhaft den Anpressdruck des Werkzeugs über einen Drucksensor zu regeln, um die Presskraft während der gesamten Pressdauer einem Sollwert anzunähern. Es können insbesondere Drucksensoren, aber auch andere Sensoren, z.B. Kraftsensoren eingesetzt werden.

Die Stössel können in einer Stösselführung gelagert sein, welche zum Erhitzen der Stössel mit einer Heizvorrichtung versehen ist. Die Stössel können dabei indirekt über wenigstens eine Heizvorrichtung auf Prozesstemperaturen bis zu 300° C erhitzt werden. Vorzugsweise bestehen die Stösselführung und die Stossel aus dem gleichen metallischen Werkstoff, damit es bei der thermischen Ausdehnung nicht zu Verklemmungen kommt. Die Stössel müssen nämlich in der Stösselführung mit sehr kleinem Spiel geführt sein, damit ausschliesslich vertikale Kräfte und keine Querkräfte an der Arbeitsfläche der Stössel wirken. Aus dem gleichen Grund sind die Stösselführungen im Verhältnis zum Durchmesser der Stossel relativ lange ausgebildet.

Um das Abstrahlen von Wärme zu vermeiden bzw. um das Bedienungspersonal zu schützen, kann das Werkzeug wenigstens teilweise von einer wärmeisolierenden Schicht umgeben sein. Das gleiche gilt auch für die Substratauflage, falls diese ebenfalls mittels einer Heizvorrichtung aufgeheizt wird. Damit auch die Arbeitstemperatur überwacht bzw protokolliert werden kann, ist sowohl im Werkzeug, als auch in der Substratauflage wenigstens ein Temperatursensor angeordnet.

Aus Sicherheitsgründen sind die Stössel im Ruhezustand des Werkzeugs unter Federvorspannung in eine neutrale Ausgangslage vorgespannt, in der sie vorzugsweise vollständig in das Werkzeug eingefahren sind. Auf diese Weise können die Stössel nicht beschädigt werden, wenn das Werkzeug beispielsweise für Umrüstarbeiten aus der Werkzeughalterung entfernt wird. Ausserdem ist damit gewährleistet, dass die Stösselrückseiten in der Ausgangslage gleichförmig an der Membrane der Flüssigkeitskammer anliegen. Schliesslich ist mit der Federvorspannung auch gewährleistet, dass die Stössel zur optimalen Wärmeaufnahme nach jedem Arbeitshub wieder vollstandig in die Stösselführung eintauchen.

Die Substratauflage ruht vorzugsweise auf einem justierbaren Dreibeinständer. Dadurch kann die Substratauflage auf besonders einfache Weise planparallel auf die Arbeitsebene der Stössel ausgerichtet werden. Auch diese Massnahme dient dazu, auf die Bauteile einwirkende Querkräfte zu vermeiden.

Die Vorrichtung kann besonders vorteilhaft zum Nachpressen der Chips in einer Linie zum Herstellen von Chip Scale Packages (CSP), insbesondere von Ball Grid Arrays (BGA) oder Flex BGA's verwendet werden Mit gleichen Vorrichtungen können aber auch andere Behandlungen in der Halbleiterfertigung durchgeführt werden. So beispielsweise im Bereich der Flip Chips, wobei die Chips mit Bumps geklebt, eutektisch befestigt oder gelötet werden. Die Vorrichtung eignet sich aber auch fur LOC-Prozesse (Lead on chip), bei denen die Verbindung zwischen den Chips und einem metallischen Lead Frame unter Druck und Temperatur hergestellt wird. Schliesslich wäre es auch denkbar, die erfindungsgemässe Vorrichtung für Arbeitsprozesse ausserhalb der Halbleitertechnik einzusetzen, beispielsweise im Bereich der Elektrotechnik oder der Optoelektronik.

Weitere Vorteile und Einzelmerkmale der Erfindung ergeben sich aus der nachfolgenden Beschreibung eines Ausführungsbeispiels und aus den Zeichnungen. Es zeigen:
- Figur 1: eine stark vereinfachte perspektivische Darstellung eines Behandlungsverfahrens,
- Figur 2: eine schematische Darstellung einer Behandlungsvorrichtung,
- Figur 3: ein Querschnitt durch eine Gruppe von Bauteilen mit unterschiedlicher Bauhöhe, und
- Figur 4: eine schematische Gesamtdarstellung der Vorrichtung gemäss Figur 2 in einer Presse.

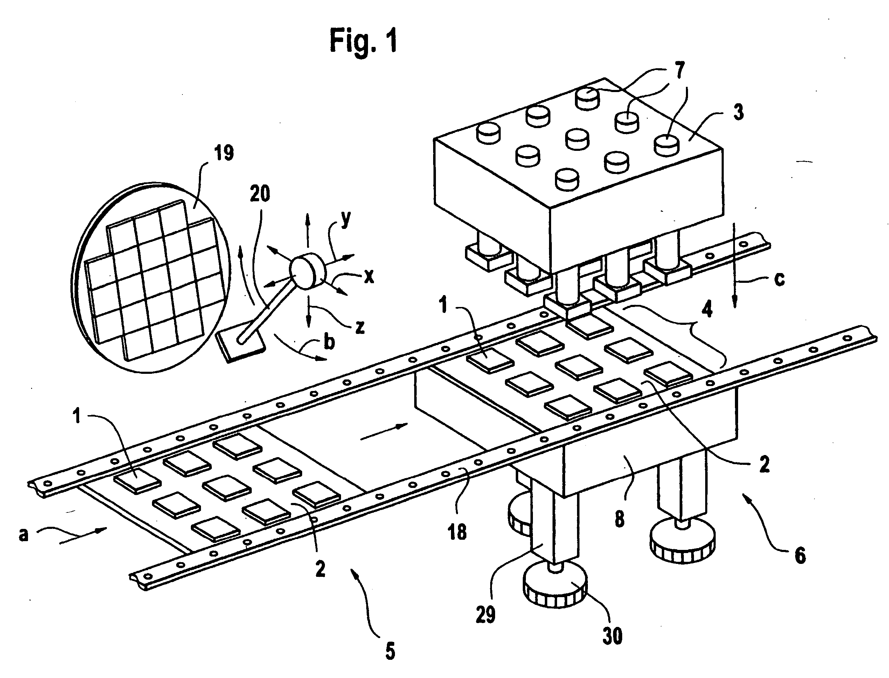

Figur 1 zeigt einen Ausschnitt aus einer Fertigungslinie für die Herstellung von Halbleiterelementen. Dargestellt wird dabei eine Aufsetzstation 5 und eine Nachpressstation 6, die aber beide Bestandteil der gleichen Anlage sein können. Auf einem Substratvorschub 18 wird durch geeignete hier nicht naher dargestellte Vorschubmittel ein Substrat 2 in Pfeilrichtung a vorgeschoben. Beim Substrat kann es sich dabei beispielsweise um einen Polyimidfilm handeln, der an einer vorausgehenden Arbeitsstation grossflächig mit einem Klebermaterial beschichtet wurde.

An der Aufsetzstation werden mit an sich bekannten Mitteln, beispielsweise mit einem konventionellen Die Bonder Silizium-Chips 1 auf das Substrat 2 abgesetzt Die Chips werden mit Hilfe eines Aufnahmearms 20 von einem Wafer 19 abgenommen und platziert. Der Aufnahmearm pendelt dabei in Pfeilrichtung b hin und her und er kann ausserdem in den drei verschiedenen Raumachsen x, y, z bewegt werden. Dabei ist auch ein Wenden der Relativlage des Chips zwischen dem Wafer und dem Substrat möglich (Flip Chip).

Sobald an der Aufsetzstation 5 eine vorher lagemässig definierte Gruppe 4 von Chips 1 abgelegt ist, wird das Substrat zur Nachpressstation 6 weitertransportiert. Die Chips können sich dabei lagemässig nicht verschieben, obwohl noch keine intensive Verbindung mit dem Substrat besteht. Eine dauernde Verbindung wird erst durch das Nachpressen und Aufheizen mit Hilfe des Werkzeugs 3 erreicht. Bei dieser Behandlung liegt das Substrat 2 auf einer ebenen Substratauflage 8. Das Werkzeug 3 kann in Pfeilrichtung c planparallel gegen diese Substratauflage gepresst werden. Jedem einzelnen Chip 1 auf dem Substrat 2 ist im Werkzeug 3 ein eigener Stössel 7 zugeordnet, der ebenfalls in Pfeilrichtung c verschiebbar gelagert ist. Die Substratauflage 8 steht auf einem Dreibeinständer 29, dessen relative Lage mit Justierschrauben 30 eingestellt werden kann. Diese Justiermöglichkeit erlaubt eine planparallele Anpassung an die Arbeitsfläche der Stössel. Der Justiervorgang könnte mit ansich bekannten Mitteln auch automatisiert werden.

Das Werkzeug 3 wird während einer bestimmten Presszeit gegen die Substratauflage 8 gepresst, wobei über die Stössel 7 bzw. über die Substratauflage gleichzeitig der Klebstoff durch Erhitzung ausgehärtet wird. Während dieser Anpresszeit wird an der Aufsetzstation 5 wiederum eine neue Gruppe von Chips auf ein neues Substrat abgesetzt.

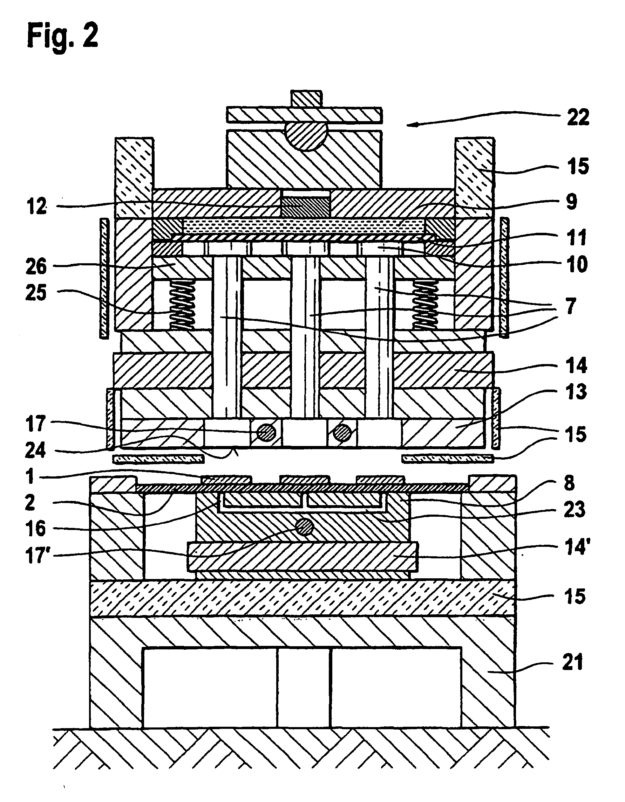

Weitere Einzelheiten der Nachpressstation 6 sind aus Figur 2 ersichtlich. Die Substratauflage 8 ruht auf einem Maschinengestell 21. Zum Fixieren des Substrats 2 in einer genau definierten Presslage sind Saugöffnungen 16 vorgesehen, welche über eine Saugleitung 23 an eine nicht dargestellte Unterdruckquelle anschliessbar sind. Die Substratauflage kann mittels wenigstens einer eingebauten Heizpatrone 14' erhitzt werden. Zur Temperaturkontrolle dient ein Temperatursensor 17'. Um Wärmeverluste zu vermeiden ist die Substratauflage gegenüber dem Maschinengestell mit einer Wärmeisolation 15 abgeschirmt.

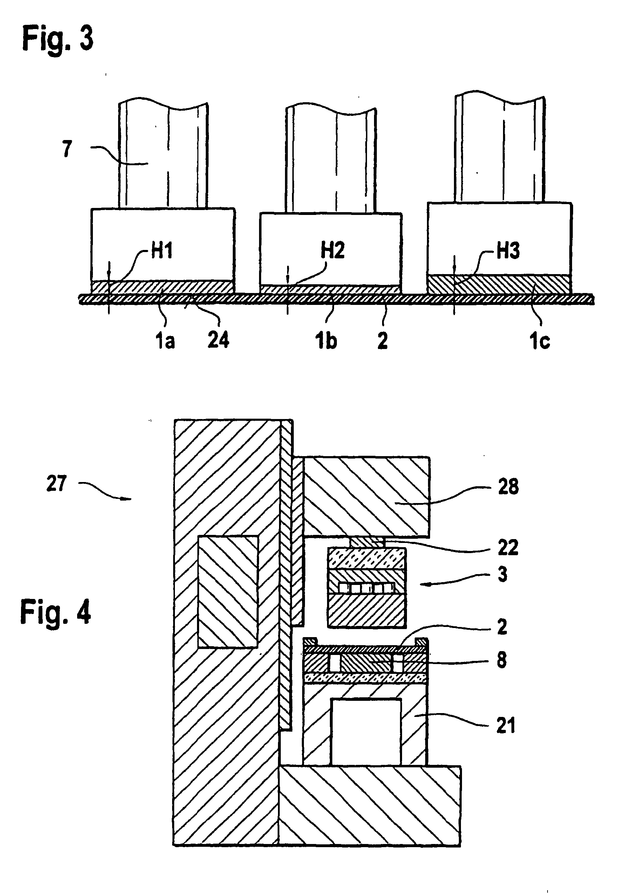

Das Werkzeug 3 kann mittels einer Werkzeughalterung 22 in den Ausleger 28 einer konventionellen Presse 27 (Figur 4) eingespannt werden. Das Werkzeug verfügt über eine Stösselführung 13, in welcher die einzelnen Stössel 7 achsparallel verschiebbar gelagert sind. Über sämtliche Stösselrückseiten 10 erstreckt sich eine Flüssigkeitskammer 9, die gegenüber den Stösseln mit einer flexiblen Membrane 11 abgedichtet ist. Die Stösselrückseiten werden mit Hilfe einer Mitnehmerplatte 26 unter der Vorspannung von Druckfedern 25 gegen die Membrane gepresst. In dieser Ausgangsposition sind die Stösselstirnseiten 24 ausserdem in das Werkzeug 3 eingefahren bzw. sie verlaufen etwa in der gleichen Ebene wie die Unterseite der Stösselführung 13.

Die Flüssigkeitskammer 9 steht in Wirkverbindung mit einem Drucksensor 12. Ausserdem sind auch an der Stösselführung 13 Temperatursensoren 17 angeordnet Das Aufheizen der Stösselführung und damit der darin gelagerten Stössel 7 erfolgt ebenfalls über wenigstens eine Heizpatrone 14. Ebenso ist das Werkzeug möglichst geschlossen mit einer wärmeisolierenden Schicht 15 abgedeckt.

Die Wirkungsweise der Flüssigkeitskammer 9 ist anhand der Figur 3 dargestellt. Auf dem Substrat 2 sind nebeneinander drei Chips 1a, 1b und 1c angeordnet. Der Chip 1a hat dabei die vorgeschriebene Sollbauhohe H1 während der Chip 1b die Mindestbauhöhe H2 und der Chip 1c die Maximalbauhöhe H3 aufweist. Wurden diese drei Chips mit der gleichen Pressplatte planparallel zur Substratauflage 18 gepresst, so würde die Pressplatte ersichtlicherweise den Chip 1c am meisten belasten und möglicherweise beschädigen, während der Chip 1b eventuell überhaupt nicht belastet würde. Unter Verwendung der Flüssigkeitskammer kann sich aber jeder Stössel in Folge seiner Verschiebbarkeit der Bauhöhe des Chips anpassen, während durch das Anliegen an der flexiblen Membrane 11 eine gleichmässige Presskraftverteilung gewährleistet ist. Je nach Presse kann pro Stössel eine Presskraft bis zu 9 bar (1 bar = 10⁵ Pa) aufgebracht werden.

## Patentansprüche

1. Verfahren zum Behandeln von auf einem Substrat (2) angeordneten elektronischen Bauteilen (1), bei dem die Bauteile auf das Substrat aufgelegt und zum dauernden Verbinden mit dem Substrat gegebenenfalls unter Verwendung eines Klebstoffs von einem Werkzeug (3) beaufschlagt und einem Anpressdruck und gegebenenfalls einer Wärmebehandlung unterworfen werden, wobei mehrere Bauteile nacheinander zu einer Gruppe (4) auf dem Substrat aufgelegt werden und anschliessend die ganze Gruppe gleichzeitig dem Anpressdruck und gegebenenfalls der Wärmebehandlung unterworfen wird, **dadurch gekennzeichnet, dass** jedes Bauteil (1) der Gruppe (4) mit einem separaten Stössel (7) beaufschlagt wird und dass bei der Beaufschlagung zur Erzielung einer gleichförmigen Auflagekraft auf allen Bauteilen jeder Stössel der individuellen Höhe des Bauteils angepasst wird.

2. Verfahren nach Anspruch 1, **dadurch gekennzeichnet, dass** das Auflegen der Bauteile (1) auf das Substrat (2) und das Beaufschlagen mit dem Werkzeug (3) an im Abstand voneinander angeordneten Arbeitsstationen (5, 6) erfolgt.

3. Verfahren nach Anspruch 1 oder 2, **dadurch gekennzeichnet, dass** vor und/oder während der Beaufschlagung der Bauteile die Stössel und/oder eine als Widerlager dienende Substratauflage (8) beheizt werden.

4. Vorrichtung zum Behandeln von auf einem Substrat (2) angeordneten elektronischen Bauteilen (1), mit einer Substratauflage (8) und mit einem gegen die Substratauflage bewegbaren Werkzeug (3) zum Beaufschlagen der Bauteile mittels Druck und gegebenenfalls Wärme, wobei das Werkzeug (3) zum gleichzeitigen Beaufschlagen einer Gruppe (4) von Bauteilen mehrere einzeln in Bewegungsrichtung des Werkzeugs (3) verschiebbar gelagerte Stössel (7) aufweist, **dadurch gekennzeichnet, dass** die Stössel (7) mit einem Kompensationsmittel zum Kompensieren unterschiedlicher Höhen der Bauteile (1) während der Beaufschlagung derart in Wirkverbindung stehen, dass beim Bewegen des Werkzeugs gegen die Substratauflage jedes Bauteil mit einer gleichen Auflagekraft beaufschlagbar ist.

5. Vorrichtung nach Anspruch 4, **dadurch gekennzeichnet, dass** das Kompensationsmittel eine Flüssigkeitskammer (9) für die hydrostatische Verteilung der Beaufschlagungskraft auf die einzelnen Stössel (7) ist.

6. Vorrichtung nach Anspruch 5, **dadurch gekennzeichnet, dass** die Flüssigkeitskammer (9) auf den von der Substratauflage abgewandten Rückseiten (10) der Stössel (7) angeordnet ist und eine flexible Membrane (11) aufweist und dass die Rückseiten der Stössel an der Membrane anliegen.

7. Vorrichtung nach einem der Ansprüche 4 bis 6, **dadurch gekennzeichnet, dass** die Stössel (7) in einer Stösselführung (13) gelagert sind, welche zum Erhitzen der Stössel mit einer Heizvorrichtung (14) versehen ist.

8. Vorrichtung nach Anspruch 7, **dadurch gekennzeichnet, dass** die Stössel (7) und die Stösselführung (13) aus dem gleichen metallischen Werkstoff bestehen und dass die Heizvorrichtung (14) wenigstens eine elektrische Heizpatrone ist.

9. Vorrichtung nach Anspruch 7 oder 8, **dadurch gekennzeichnet, dass** das Werkzeug (3) wenigstens teilweise von einer wärmeisolierenden Schicht (15) umgeben ist.

10. Vorrichtung nach einem der Ansprüche 4 bis 9, **dadurch gekennzeichnet, dass** sowohl im Werkzeug, als auch in der Substratauflage Temperatursensoren zum Überwachen der Behandlungstemperatur angeordnet sind.

11. Vorrichtung nach einem der Ansprüche 4 bis 10, **dadurch gekennzeichnet, dass** die Stössel (7) im Ruhezustand des Werkzeugs (3) unter Federvorspannung in eine neutrale Ausgangslage vorgespannt sind, in der sie in das Werkzeug eingefahren sind.

12. Vorrichtung nach einem der Ansprüche 4 bis 11, **dadurch gekennzeichnet, dass** die Substratauflage (8) auf einem Dreibeinständer ruht, der für die planparallele Ausrichtung der Substratauflage auf die Ebene der Stössel justierbar ist.

13. Vorrichtung nach einer der Ansprüche 4 bis 12, **dadurch gekennzeichnet, dass** der Anpressdruck des Werkzeugs (3) über einen am Werkzeug angebrachten Sensor (12), insbesondere einem Drucksensor regelbar ist.

14. Vorrichtung nach Anspruch 13, **dadurch gekennzeichnet, dass** der Drucksensor (12) mit der Flüssigkeitskammer (9) in Wirkverbindung steht.

15. Verwendung einer Vorrichtung nach einem der Ansprüche 4 bis 14, zum Nachpressen der Chips in einer Linie zum Herstellen von Chip Scale Packages (CSP's), insbesondere von Ball Grid Array (BGA's).

## Claims

1. A method of treating electronic components (1) arranged on a substrate (2), in which the components are placed on the substrate and for permanent connection to the substrate are acted upon by a tool (3) optionally with the use of an adhesive and are subjected to a pressing pressure and optionally a heat treatment, wherein a plurality of components are successively placed on the substrate to form a group (4) and then the entire group is simultaneously subjected to the pressing pressure and optionally the heat treatment, **characterised in that** each component (1) of the group (4) is acted upon by a separate plunger (7) and that in the operation of acting on the components to achieve a uniform placement force on all components each plunger is adapted to the individual height of the component.

2. A method according to claim 1 **characterised in that** the operation of placing the components (1) on the substrate (2) and acting thereon with the tool (3) are effected at mutually spaced working stations (5, 6).

3. A method according to claim 1 or 2 **characterised in that** prior to and/or during the operation of acting on the components the plungers and/or a substrate support (8) serving as an abutment means are heated.

4. Apparatus for treating electronic components (1) arranged on a substrate (2), comprising a substrate support (8) and a tool (3) movable towards the substrate support for acting on the components by means of pressure and optionally heat, wherein for simultaneously acting on a group (4) of components the tool (3) has a plurality of plungers (7) which are mounted displaceably individually in the direction of movement of the tool (3), **characterised in that** the plungers (7) are operatively connected to a compensation means for compensating for different heights of the components (1) during the operation of acting on the components in such a way that when the tool moves towards the substrate support each component can be acted upon by an equal placement force.

5. Apparatus according to claim 4 **characterised in that** the compensation means is a fluid chamber (9) for hydrostatic distribution of the plunger force to the individual plungers (7).

6. Apparatus according to claim 6 **characterised in that** the fluid chamber (9) is arranged on the rear sides (10) of the plungers (7), which sides are remote from the substrate support, and has a flexible diaphragm (11), and that the rear sides of the plungers bear against the diaphragm.

7. Apparatus according to one of claims 4 to 6 **characterised in that** the plungers (7) are mounted in a plunger guide (13) provided with a heating device (14) for heating the plungers.

8. Apparatus according to claim 7 **characterised in that** the plungers (7) and the plunger guide (13) comprise the same metal material and that the heating device (14) has at least one electric heating cartridge.

9. Apparatus according to claim 7 or claim 8 **characterised in that** the tool (3) is at least partially enclosed by a heat-insulating layer (15).

10. Apparatus according to one of claims 4 to 9 **characterised in that** temperature sensors -for monitoring the treatment temperature are arranged both in the tool and also in the substrate support.

11. Apparatus according to one of claims 4 to 10 **characterised in that** in the rest condition of the tool (3) the plungers (7) are biased under a spring biasing force into a neutral starting position in which they are retracted into the tool.

12. Apparatus according to one of claims 4 to 11 **characterised in that** the substrate support (8) rests on a three-legged stand which is adjustable for plane-parallel alignment of the substrate support to the plane of the plungers.

13. Apparatus according to one of claims 4 to 12 **characterised in that** the pressing pressure of the tool (3) is regulatable by way of a sensor (12) mounted to the tool, in particular a pressure sensor.

14. Apparatus according to claim 13 **characterised in that** the pressure sensor (12) is operatively connected to the fluid chamber (9).

15. Use of an apparatus according to one of claims 4 to 14 for post- pressing the chips in a line for the production of chip scale packages (CSPs), in particular ball grid arrays (BGAs).

## Revendications

1. Procédé pour traiter des composants électroniques (1) disposés sur un substrat (2), selon lequel les composants sont posés sur le substrat et, en vue d'une liaison durable avec celui-ci, sont sollicités par un outil (3), éventuellement avec utilisation d'une colle, et soumis à une pression de serrage et éventuellement à un traitement thermique, étant précisé que plusieurs composants sont posés successivement sur le substrat pour former un groupe (4) et que l'ensemble du groupe est ensuite soumis simultanément à ladite pression de serrage et éventuellement au traitement thermique, **caractérisé en ce que** chaque composant (1) du groupe (4) est sollicité avec un poussoir (7) distinct, et **en ce que** lors de la sollicitation, chaque poussoir est adapté à la hauteur individuelle du composant afin qu'on obtienne une force d'application égale sur tous les composants.

2. Procédé selon la revendication 1, **caractérisé en ce que** la pose des composants (1) sur le substrat (2) et la sollicitation avec l'outil (3) se font sur des postes de travail (5, 6) espacés les uns des autres.

3. Procédé selon la revendication 1 o 2, **caractérisé en ce qu'**avant et/ou pendant la sollicitation des composants, les poussoirs et/ou un support de substrat (8) servant de contre-appui sont chauffés.

4. Dispositif pour traiter des composants électroniques (1) disposés sur un substrat (2), comportant un support de substrat (8) et un outil (3) qui est apte à être déplacé vers celui-ci et qui est destiné à solliciter les composants à l'aide d'une pression et éventuellement de chaleur, l'outil (3) comportant, pour solliciter simultanément un groupe (4) de composants, plusieurs poussoirs (7) qui sont montés mobiles individuellement dans le sens de déplacement de l'outil (3), **caractérisé en ce que** les poussoirs (7) sont en relation fonctionnelle avec un moyen de compensation pour compenser les hauteurs différentes des composants (1), pendant la sollicitation, de telle sorte que lors du déplacement de l'outil vers le support de substrat, chaque composant soit apte à être sollicité avec la même force d'application.

5. Dispositif selon la revendication 4, **caractérisé en ce que** le moyen de compensation consiste en une chambre de liquide (9) pour la répartition hydrostatique de la force de sollicitation sur les poussoirs individuels (7).

6. Dispositif selon la revendication 5, **caractérisé en ce que** la chambre de liquide (9) est disposée sur les côtés arrière (10) des poussoirs (7) qui sont opposés au support de substrat et présente une membrane flexible (11), et **en ce que** les côtés arrière des poussoirs sont appliqués contre ladite membrane.

7. Dispositif selon l'une des revendications 4 à 6, **caractérisé en ce que** les poussoirs (7) sont montés dans un guide de poussoirs (13) qui est pourvu, en vue du chauffage desdits poussoirs, d'un dispositif chauffant (14).

8. Dispositif selon la revendication 7, **caractérisé en ce que** les poussoirs (7) et le guide de poussoirs (13) se composent du même matériau métallique, et **en ce que** le dispositif chauffant (14) consiste en au moins une cartouche chauffante électrique.

9. Dispositif selon la revendication 7 ou 8, **caractérisé en ce que** l'outil (3) est entouré au moins partiellement par une couche calorifuge (15).

10. Dispositif selon l'une des revendications 4 à 9, **caractérisé en ce que** des capteurs de températures destinés à surveiller la température de traitement sont disposés aussi bien dans l'outil que dans le support de substrat.

11. Dispositif selon l'une des revendications 4 à 10, **caractérisé en ce que** dans la position de repos de l'outil (3), les poussoirs (7) sont contraints par un ressort dans une position de départ neutre dans laquelle ils sont rétractés dans l'outil.

12. Dispositif selon l'une des revendications 4 à 11, **caractérisé en ce que** le support de substrat (8) est posé sur un trépied qui est ajustable pour que ledit support de substrat soit aligné parallèlement au plan des poussoirs.

13. Dispositif selon l'une des revendications 4à 12, **caractérisé en ce que** la pression de serrage de l'outil (3) est réglable par l'intermédiaire d'un capteur (12) monté sur l'outil, en particulier un capteur de pression.

14. Dispositif selon la revendication 13, **caractérisé en ce que** le capteur de pression (12) est en relation fonctionnelle avec la chambre de liquide (9).

15. Utilisation d'un dispositif selon l'une des revendications 4 à 14 pour recomprimer les puces dans une chaîne de fabrication de boîtiers CSP (Chip Scale Package), en particulier des boîtiers BGA (Ball Grid Array).
